# EUROPEAN PATENT APPLICATION

(11) **EP 1 956 875 A2**
(43) Date of publication of application: **13.08.2008**
(21) Application number: 08150845.9
(22) Date of filing: 30.01.2008
(51) Int. Cl.: H05K 3/24, H05K 1/11, H05K 3/40

(54) **Wired circuit board and method for producing the same**

(30) Priority: 09.02.2007 JP 2007031137
(71) Applicant: Nitto Denko Corporation, Ibaraki-shi, Osaka 567-8680 (JP)
(72) Inventor: Kamei, Katsutoshi Nitto Denko Corporation, Osaka 567-8680 (JP); Nakamura, Kazuya, Nagoya-shi, Aichi 463-0013 (JP); Thaveerprungsriporn, Visit Nitto Denko Corp., Osaka 567-8680 (JP)
(74) Representative: Schwabe - Sandmair - Marx

(57) **Abstract**

A wired circuit board includes: a first insulating layer; a conductive pattern formed on the first insulating layer and having a terminal portion; and a second insulating layer formed on the first insulating layer to cover the conductive pattern. A surface of the terminal portion is formed to be exposed from the first insulating layer and the second insulating layer. A tin alloy layer is formed at least on a top surface and both side surfaces of the terminal portion.

## Description

### BACKGROUND OF THE INVENTION

### Field of the Invention

The present invention relates to a wired circuit board and a method for producing the same and, more particularly, to a wired circuit board used suitably as a suspension board with circuit and a method for producing the same.

### Description of the Related Art

A wired circuit board used in electronic/electric equipment typically includes an insulating base layer, a conductive pattern formed on the insulating base layer, and an insulating cover layer formed on the insulating base layer to cover the conductive pattern. The conductive pattern has a terminal portion exposed from the insulating cover layer.

As electronic/electric equipment has become thinner and smaller in recent years, a space in which the wired circuit board is placed has also been reduced in area. To cope with the reduced placement space, it is known that the terminal portion is formed as a flying lead exposing a top surface and a back surface each from the insulating base layer and the insulating cover layer.

For example, it is proposed to form a flying lead as a terminal portion in a suspension board with circuit used in a hard disk drive (see, e.g., Japanese Unexamined Patent Publication No. 2006-202358).

### SUMMARY OF THE INVENTION

The top surface and back surface of the flying lead are typically connected to respective external terminals using a bonding tool or the like and applying ultrasonic vibration thereto. However, because the flying lead is exposed from the insulating base layer and the insulating cover layer, it has the problem that of a wire is breakable.

On the other hand, as a wiring pitch becomes finer in recent years, a further improvement is required in strength of wiring. However, it is difficult for such a flying lead to fully satisfy such a requirement.

An object of the present invention is to provide a wired circuit board which allows a sufficient improvement in the strength of a terminal portion formed as a flying lead and a method for producing the same.

To attain the object, a wired circuit board according to the present invention comprises a first insulating layer, a conductive pattern formed on the first insulating layer and having a terminal portion, and a second insulating layer formed on the first insulating layer to cover the conductive pattern, wherein a surface of the terminal portion is formed to be exposed from the first insulating layer and the second insulating layer and a tin alloy layer is formed at least on a top surface and both side surfaces of the terminal portion.

In the wired circuit board according to the present invention, it is preferable that the tin alloy layer is further formed on a back surface of the terminal portion.

In the wired circuit board according to the present invention, it is preferable that a gold plating layer is formed on a surface of at least the tin alloy layer at the terminal portion.

In the wired circuit board according to the present invention, it is preferable that the tin alloy layer has a thickness of 1.0 to 3.0 µm.

In the wired circuit board according to the present invention, it is preferable that the conductive pattern is formed of copper, and the tin alloy layer is a tin-copper alloy layer formed by diffusing tin into copper.

It is preferable that the wired circuit board according to the present invention is a suspension board with circuit.

In the wired circuit according to the present invention, the tin alloy layer is formed at least on the top surface and both side surfaces of the terminal portion. This allows a sufficient improvement in the strength of the terminal portion. As a result, it is possible to obtain the wired circuit board with high connection reliability.

A method for producing a wired circuit board according to the present invention comprises the steps of preparing a metal supporting board, forming an insulating base layer on the metal supporting board, forming a conductive pattern having a terminal portion and formed of copper on the insulating base layer, forming a tin layer at least on a top surface and both side surfaces of the terminal portion, forming an insulating cover layer on the insulating base layer to cover the conductive pattern and exposing the top surface and both the side surfaces of the terminal portion, forming a tin-copper alloy layer by heating the tin layer to diffuse tin into copper at least on the top surface and both the side surfaces of the terminal, and forming a metal opening and a base opening respectively in the metal supporting board and the insulating base layer to expose a back surface of the terminal portion.

It is preferable that the method for producing a wired circuit board according to the present invention further comprises the step of forming a gold plating layer on a surface of the at least tin-copper alloy layer at the terminal portion.

In the method for producing a wired circuit board according to the present invention, it is preferable that the step of forming the insulating cover layer comprises the steps of laminating an uncured resin, and curing the laminated uncured resin by heating, wherein the step of curing the uncured resin by heating and the step of forming the tin-copper alloy layer are carried out simultaneously.

In the method for producing a wired circuit board according to the present invention, it is preferable that the tin layer has a thickness of 0.01 to 0.20 µm.

In the method for producing the wired circuit board according to the present invention, the tin alloy layer is formed at least on the top surface and both side surfaces of the terminal portion. This allows a sufficient improvement in the strength of the terminal portion. As a result, it is possible to obtain the wired circuit board with high connection reliability.

### BRIEF DESCRIPTION OF THE DRAWINGS

FIG. 1 is a principal-portion plan view showing a suspension board with circuit as an embodiment of a wired circuit board according to the present invention.
FIG. 2 is a cross-sectional view of both the ends of the suspension board with circuit shown in FIG. 1, including a left-side view which is a partial cross-sectional view along a longitudinal direction and a right-side view which is a cross-sectional view along a widthwise direction.
FIG. 3 is a production process view showing a method for producing the suspension board with circuit shown in FIG. 2 as an embodiment of a method for producing the wired circuit board according to the present invention,
   (a) showing the step of preparing a metal supporting board,
   (b) showing the step of forming an insulating base layer on the metal supporting board,
   (c) showing the step of forming a conductive pattern on the insulating base layer,
   (d) showing the step of forming a tin layer on the top surface and side surfaces of the conductive pattern including terminal portions,
   (e) showing the step of forming a cover coating, and
   (f) showing the step of curing an uncured cover coating by heating and forming a tin alloy layer.

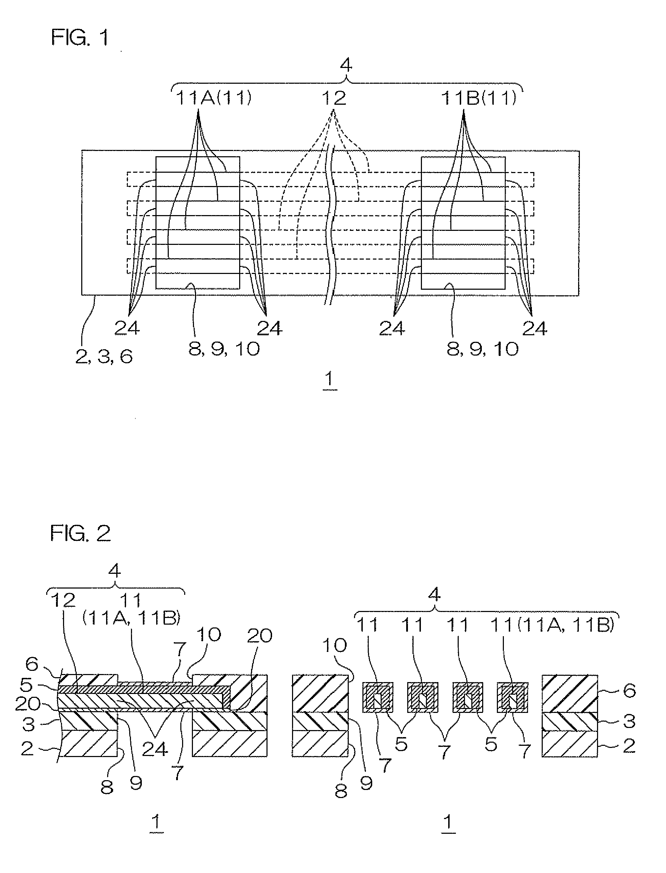

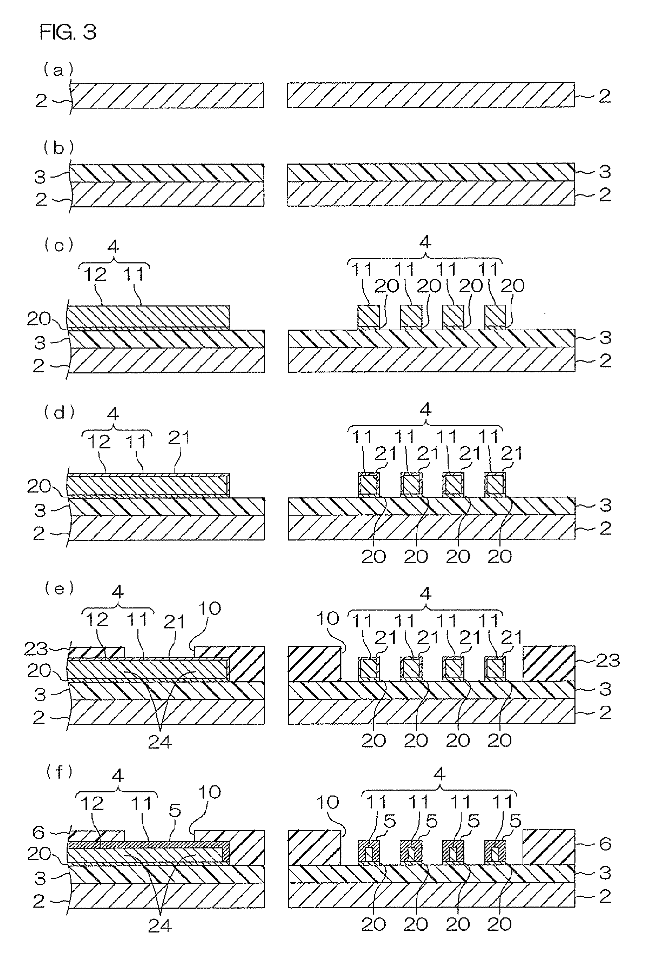

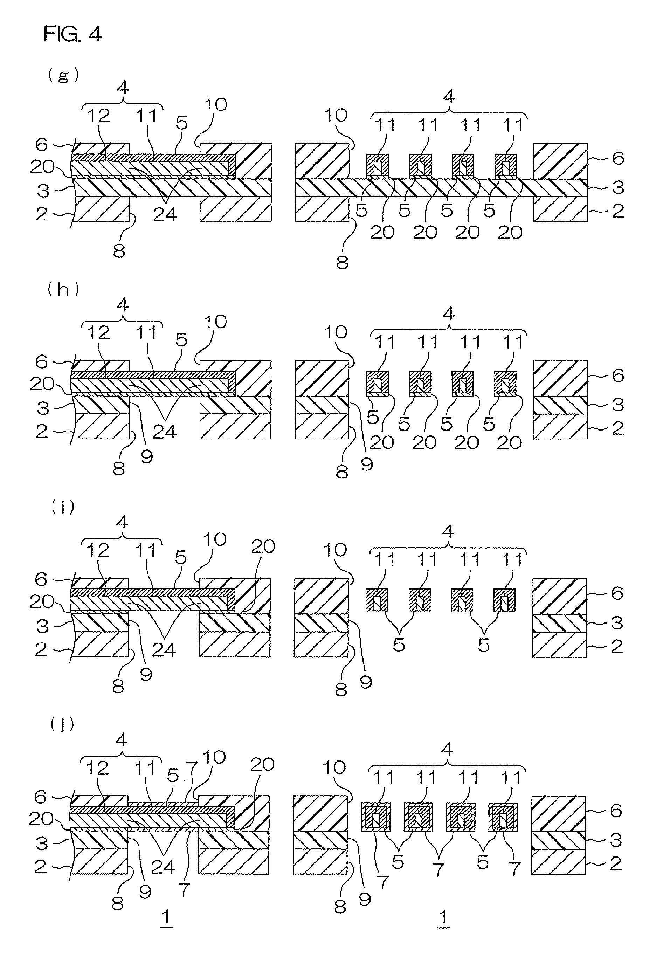

FIG. 4 is a production process view subsequently to FIG. 3, showing the method for producing the suspension board with circuit shown in FIG. 2 as the embodiment of the method for producing the wired circuit board according to the present invention,
   (g) showing the step of forming metal openings in the metal supporting board,
   (h) showing the step of forming base openings in the insulating base layer,
   (i) showing the step of removing underlays, and
   (j) showing the step of forming a metal plating layer on the top surface of the tin alloy layer in the terminal portions and on the back surface in the terminal portions.

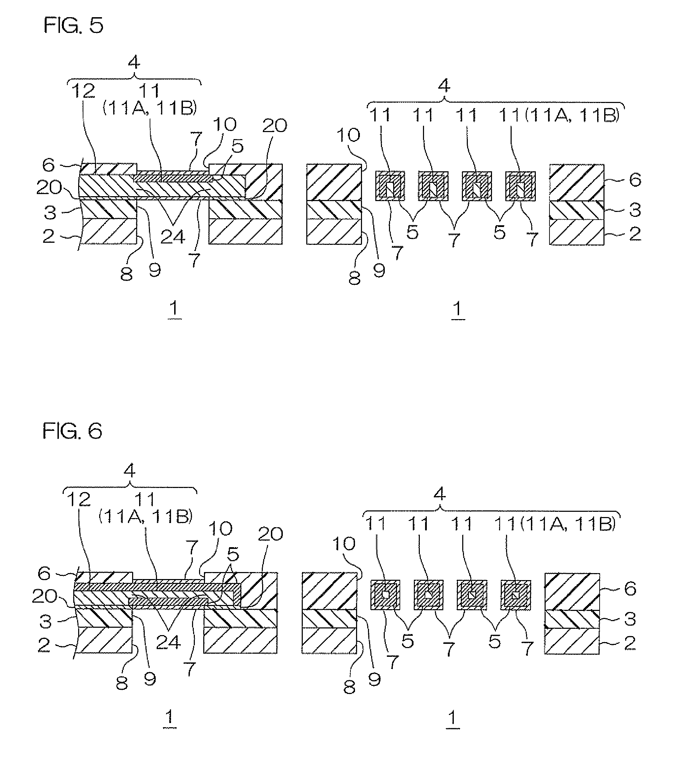

FIG. 5 is a cross-sectional view of both the ends of a suspension board with circuit as another embodiment (in which the tin alloy layer is formed only on the top surface and both side surfaces of the terminal portions) of the wired circuit board according to the present invention, including a left-side view which is a partial cross-sectional view along the longitudinal direction and a right-side view along the widthwise direction.
FIG. 6 is a cross-sectional view of both the ends of a suspension board with circuit as still another embodiment (in which the tin alloy layer is formed on the top surface, both side surfaces, and back surface of the terminal portions) of the wired circuit board according to the present invention, including a left-side view which is a partial cross-sectional view along the longitudinal direction and a right-side view along the widthwise direction.

### DETAILED DESCRIPTION OF PREFERRED EMBODIMENTS

FIG. 1 is a principal-portion plan view showing a suspension board with circuit as an embodiment of a wired circuit board according to the present invention. FIG. 2 is a cross-sectional view of both the ends of the suspension board with circuit shown in FIG. 1, including a left-side view which is a partial cross-sectional view in the longitudinal direction of the suspension board with circuit (hereinafter may be referred to simply as the "longitudinal direction") and a right-side view which is a cross-sectional view along a perpendicular direction to the longitudinal direction of the suspension board with circuit (hereinafter may be referred to simply as a "widthwise direction").

The suspension board with circuit 1 is attached to a hard disk drive to mount a magnetic head for supporting the magnetic head in facing relation to a magnetic disk and formed with a conductive pattern 4 for connecting the magnetic head and an external circuit of a read/write board or the like.

As shown in the left-side view of FIG. 2, the suspension board with circuit 1 includes a metal supporting board 2, an insulating base layer 3 as a first insulating layer formed on the metal supporting board 2, the conductive pattern 4 formed on the insulating base layer 3, and an insulating cover layer 6 as a second insulating layer formed on the insulating base layer 3 to cover the conductive pattern 4.

As shown in FIG. 1, the metal supporting board 2 is in the shape of a rectangular thin plate extending in the longitudinal direction when viewed in plan view and formed of a metal foil or a metal thin plate. The metal supporting board 2 has a thickness in the range of, e.g., 10 to 60 µm, or preferably 15 to 30 µm.

The insulating base layer 3 is formed to be laminated on the top surface of the metal supporting board 2. More specifically, the insulating base layer 3 is formed on the metal supporting board 2 to have a pattern corresponding to the portion of the conductive pattern 4 where wires 12 are formed. The insulating base layer 3 has a thickness in the range of, e.g., 1 to 30 µm, or preferably 2 to 20 µm.

The conductive pattern 4 integrally includes magnetic-head-side connection terminal portions 11A, external connection terminal portions 11B, and the wires 12 for connecting the magnetic-head-side connection terminal portions 11A and the external connection terminal portions 11B.

The plurality of (four) wires 12 are provided along the longitudinal direction to be arranged in widthwise parallel and mutually spaced-apart relation.

The magnetic-head-side connection terminal portions 11A are arranged at the front end portion of the metal supporting board 2 to be spaced apart in parallel from each other along the widthwise direction. The plurality of (four) magnetic-head-side connection terminals portions 11A are provided to be connected to the respective front ends of the wires 12.

As shown in FIG. 2 and described later, the magnetic-head-side connection terminals portions 11A is provided such that respective back surfaces are exposed from the metal supporting board 2 and the insulating base layer 3 and respective top surfaces are exposed from the insulating cover layer 6. To the magnetac-head-side connection terminal portions 11A, a terminal portion (not shown) of the magnetic head is connected.

As shown in FIG. 1, the external connection terminal portions 11B are arranged at the rear end portion of the metal supporting board 2 to be spaced apart in parallel from each other along the widthwise direction. The plurality of (four) external connection terminal portions 11B are provided to be connected to the respective rear ends of the wires 12.

As shown in FIG. 2 and described later, the external connection terminal portions 11B is provided such that respective back surfaces are exposed from the metal supporting board 2 and the insulating base layer 3 and respective top surfaces exposed from the insulating cover layer 6. To the external connection terminal portions 11B, a terminal portion (not shown) of the read/write board is connected.

When the conductive pattern 4 is formed by an additive method described later, underlays 20 are interposed between the respective wires 12 and the insulating base layer 3. The underlays 20 are formed on the back surfaces of the wires 12 and, more specifically, formed in the same pattern as the wires 12.

The thickness of the conductive pattern 4 is in the range of, e.g., 1 to 15 µm, or preferably 3 to 12 µm. The width of the wire 12, the width of the magnetic-head-side connection terminal portion 11A, and the width of the external connection terminal portion 11B are, e.g., the same or different from each other and in the range of, e.g., 50 to 500 µm, or preferably 80 to 300 µm. The spacing between the individual wires 12, the spacing between the individual magnetic-head-side connection terminal portions 11A, and the spacing between the individual external connection terminal portions 11B are, e.g., the same or different from each other and in the range of, e.g., 5 to 500 µm, or preferably 15 to 100 µm. The length (longitudinal length) of the respective magnetic-head-side connection terminal portions 11A and the respective external connection terminal portions 11B is in the range of, e.g., 100 to 2000µm, or preferably 500 to 1200µm. The thickness of the underlay 20 is in the range of, e.g., 1 to 6000 nm or, preferably 5 to 5000 nm.

The magnetic-head-side connection terminal portions 11A and the external connection terminal portions 11B are hereinafter simply described as a terminal portion 11 when distinction therebetween is not particularly needed.

The insulating cover layer 6 is formed to cover the conductive pattern 4 and the top surface of the insulating base layer 3 exposed from the conductive pattern 4. More specifically, the insulating cover layer 6 is formed in the same pattern as the insulating base layer 3 when viewed in plan view, as shown in FIG. 2. The thickness of the insulating cover layer 6 is in the range of, e.g., 1 to 20 µm, or preferably 2 to 10 µm.

In the suspension board with circuit 1, the metal supporting board 2, the insulating base layer 3, and the insulating cover layer 6 are opened in the portions thereof corresponding to the terminal portions 11.

More specifically, the metal supporting board 2 is formed with metal openings 8 in the portions thereof where the terminal portions 11 are formed to extend therethrough in the thickness direction. As shown in FIG. 1, the metal opening 8 is opened to have a generally rectangular shape when viewed in plan view to contain all (four) the terminal portions 11.

The insulating base layer 3 is formed with base openings 9 in the portions thereof where the terminal portions 11 are formed to extend therethrough in the thickness direction. The base openings 9 are opened to have the same shape as that of the metal openings 8 to contain all (four) the terminal portions 11 when viewed in plan view. In other words, the base openings 9 are formed to have both the longitudinal end edges thereof and both the widthwise end edges thereof located at the same positions as both the longitudinal end edges and both widthwise end edges of the metal openings 8 when viewed in plan view.

As a result, the back surfaces of the terminal portions 11 are exposed from the metal openings 8 of the metal supporting board 2 and from the base openings 9 of the insulating base layer 3.

The insulating cover layer 6 is formed with cover openings 10 in the portions thereof where the terminal portions 11 are formed to extend therethrough in the thickness direction. The cover openings 10 are opened to have the same shape as the base openings 9 to contain all (four) the terminal portions 11 when viewed in plan view. In other words, the cover openings 10 are formed to have both the longitudinal end edges thereof and both the widthwise end edges thereof located at the same positions as both the longitudinal end edges and both the widthwise end edges of the base openings 9 when viewed in plan view.

As a result, the top surfaces and both side surfaces of the terminal portions 11 are exposed from the cover openings 10 of the insulating cover layer 6.

Briefly, the terminals portions 11 are formed to have the surfaces (top surfaces, both side surfaces, and back surfaces) thereof exposed from the metal openings 8 of the metal supporting board 2, from the base openings 9 of the insulating base layer 3, and from the cover openings 10 of the insulating cover layer 6, so that the terminal portions 11 are formed as flying leads.

Additionally, in the suspension board with circuit 1, a tin alloy layer 5 is provided continuously on the top surface and individual side surfaces (i.e., both the widthwise side surfaces and both the longitudinal side surfaces) of the conductive pattern 4 (wires 12 and terminal portions 11).

The tin alloy layer 5 is formed to erode the top surface, both widthwise side surfaces, and both longitudinal side surfaces of the conductive pattern 4.

Specifically, at the wire 12, the tin alloy layer 5 is provided continuously on the top surface, both widthwise side surfaces, and both longitudinal side surfaces of the wire 12.

At the terminal portion 11, the tin alloy layer 5 is provided continuously on the top surface and both widthwise side surfaces of the terminal portion 11. The tin alloy layer 5 is formed to cover intersection portions 24 where both the longitudinal end edges of the cover openings 10 of the insulating cover layer 6 intersect the conductive pattern 4.

The thickness of the tin alloy layer 5 is in the range of, e.g., 1.0 to 3.0 µm, or preferably 2.0 to 3.0 µm. When the thickness of the tin alloy layer 5 is over the range shown above, there may be a case where a surface resistivity at the terminal portion 11 becomes excessively high. When the thickness of the tin alloy layer 5 is under the range shown above, there may be a case where the strength of the terminal portion 11 cannot be improved.

The thickness of the tin alloy layer 5 can be measured with a TOF-SIMS.

Additionally, in the suspension board with circuit 1, a gold plating layer 7 is formed on the surfaces of the tin alloy layer 5 at each of the terminal portions 11.

More specifically, the gold plating layer 7 is formed on the surfaces of the tin alloy layer 5 formed on the top surface and both side surfaces of each of the terminal portions 11, and on the back surface of the terminal portion 11 in continuous relation thereto. The thickness of the gold plating layer 7 is in the range of, e.g., 0.2 to 5 µm, or preferably 0.5 to 3 µm.

Next, referring to FIGS. 3 and 4, a description will be given to a method for producing the suspension board with circuit as an embodiment of a method for producing the wired circuit board according to the present invention.

First, as shown in FIG. 3(a), the metal supporting board 2 is prepared in the method.

Examples of a metal material used to form the metal supporting board 2 include stainless steel and 42-alloy. Preferably, stainless steel is used.

Next, in the method as shown in FIG. 3(b), the insulating base layer 3 is formed on the metal supporting board 2.

Examples of an insulating material used to form the insulating base layer 3 include a synthetic resin such as, e.g., polyimide, polyamide imide, acryl, polyether nitrile, polyether sulfone, polyethylene terephthalate, polyethylene naphthalate, polyvinyl chloride, or a fluorine resin. Preferably, a photosensitive synthetic resin is used and, more preferably, photosensitive polyimide is used.

To form the insulating base layer 3 on the metal supporting board 2 using, e.g., photosensitive polyimide, a varnish (photosensitive polyamic acid resin solution) of a photosensitive polyimide resin precursor is first uniformly coated on the entire top surface of the metal supporting board 2 and dried by heating at, e.g., 70 to 120 °C to form a base coating. Then, the base coating is exposed to light via a photomask, developed, and then cured (imidized) by heating at e.g., 350 to 400 °C to form the insulating base layer 3 in the foregoing pattern on the metal supporting board 2.

Then, in the method, as shown in FIG. 3(c), the conductive pattern 4 is formed in the foregoing pattern having the terminals portions 11 on the insulating base layer 3.

Examples of a conductive material used to form the conductive pattern 4 include copper, nickel, gold, a solder, or an alloy thereof. Preferably, copper is used.

The conductive pattern 4 is formed by a known patterning method such as, e.g., an additive method or a subtractive method. Preferably, the conductive pattern 4 is formed by the additive method.

In the additive method, the underlay 20 is formed on the entire top surface of the insulating base layer 3. Preferably, the underlay 20 is formed by successively laminating a chromium thin film and a copper thin film by chromium sputtering and copper sputtering.

Next, a plating resist, not shown, is formed in a pattern reverse to the conductive pattern 4 described above on the top surface of the underlay 20. Then, the conductive pattern 4 is formed in the foregoing pattern on the top surface of the underlay 20 exposed from the plating resist by electrolytic plating, or preferably electrolytic copper plating. Thereafter, the plating resist and the portion of the underlay 20 where the plating resist is laminated are removed.

As a result, the conductive pattern 4 can be formed in the foregoing pattern having the terminal portions 11 on the insulating base layer 3.

Next, in the method as shown in FIG. 3(d), a tin layer 21 is formed on the top surface and individual side surfaces of the conductive pattern 4.

The tin layer 21 is formed on the top surface and individual side surfaces of the conductive pattern 4 including the terminal portions 11 by, e.g., electroless tin plating.

In the electroless tin plating, when the conductive pattern 4 is made of copper, the surface of the conductive pattern 4 is etched by substitution of tin for copper. More specifically, the tin layer 21 is formed to erode the top surface, both widthwise side surfaces, and both longitudinal side surfaces of the conductive pattern 4.

In the case where the underlay 20 is formed by successively laminating a chromium thin film and a copper thin film, though not shown, the copper thin film is eroded by substitution of tin for copper. On the other hand, since tin does not substitute for chromium, the chromium thin film is not eroded. As a result, the tin layer 21 is laminated on the top surfaces of both the widthwise end edges and both longitudinal end edges of the chromium thin film.

The thickness of the tin layer 21 is in the range of, e.g., 0.01 to 0.20 µm, or preferably 0.05 to 0.15 µm. When the thickness of the tin layer 21 is outside of the range shown above, there may be a case where the thickness of the tin alloy layer 5 cannot be set to fall within the range shown above.

Next, in the method, as shown in FIG. 3(e), a cover coating 23 is formed in the foregoing pattern which exposes the tin layer 21 formed on the top surface and both widthwise side surfaces of the terminal portions 11.

The cover coating 23 is an uncured resin prior to the formation of the insulating cover layer 6. Examples of a material used for forming the cover coating 23 include the same material as an insulating material for forming, e.g., the insulating base layer 3. Preferably, a photosensitive synthetic resin is used, or more preferably, photosensitive polyimide is used.

When the cover coating 23 is formed using photosensitive polyimide, a photosensitive polyamic acid resin solution is coated on the entire top surface of the insulating base layer 3 including the conductive pattern 4 and the tin layer 21 and dried by heating at, e.g., 70 to 120°C. Next, it is exposed to light via a photomask and then developed to be formed into a pattern in which the cover openings 10 are formed. As a result, the cover coating 23 can be formed in the foregoing pattern which exposes the tin layer 21 formed on the top surface and both widthwise side surfaces of the terminal portions 11.

Next, in the method, as shown in FIG. 3(f), the uncured cover coating 23 thus formed is cured by heating and the tin alloy layer 5 is formed simultaneously.

In the tin alloy for forming the tin alloy layer 5, a metal material for forming an alloy with tin is the conductive material of the conductive pattern 4 mentioned above, or preferably copper. That is, the tin alloy for forming the tin alloy layer 5 is preferably a tin-copper alloy.

To cure the cover coating 23 by heating and form the tin alloy layer 5 simultaneously, the suspension board with circuit 1 in the process of production on which, e.g., the cover coating 23 is formed is heated at 350 to 450 °C, or preferably 350 to 400 °C for, e.g., 60 to 300 minutes, or preferably 120 to 300 minutes, under, e.g., a reduced pressure in an oxygen containing atmosphere such as the air or, e.g., an inert gas atmosphere such as nitrogen, or preferably the inert gas atmosphere.

By the heating, the uncured cover coating 23 is cured and tin is simultaneously diffused into the conductive material of the conductive pattern 4, while the conductive material of the conductive pattern 4 is diffused into the tin, so that the tin-alloy layer 5 is formed. Preferably, when the conductive pattern 4 is made of copper, tin is diffused into copper, while copper is diffused into the tin, so that the tin-copper alloy layer 5 is formed.

In the diffusion of tin, the tin in the tin layer 21 formed on the top surface of the conductive pattern 4 is diffused downwardly, while the tin in the tin layer 21 formed on both the widthwise side surfaces and both the longitudinal side surfaces of the conductive pattern 4 is diffused inwardly in the widthwise direction and inwardly in the longitudinal direction. As a result, the tin alloy layer 5 is formed to have a thickness larger than that of the tin layer 21 before heating.

By the diffusion of tin, the tin layer 21 is replaced by the tin alloy layer 5 so that the tin layer 21 substantially disappears.

In the tin alloy layer 5, the concentration of tin, i.e., the weight ratio of diffused tin is calculated from the thickness of the tin layer 21 before heating and that of the tin alloy layer 5 after heating, which is, e.g., 0.08% to 1.6% by weight, or preferably 0.4% to 1.2% by weight.

In the tin alloy layer 5, the tin is diffused to have distributions in the thickness direction, in the widthwise direction, and in the longitudinal direction such that the concentration of tin is highest in the uppermost layer and gradually lowers with distance from the uppermost layer towards a lower portion in the thickness direction, an inner portion in the widthwise direction, and an inner portion in the longitudinal direction.

Next, in the method, as shown in FIG. 4(g), the metal openings 8 are formed in the metal supporting board 2.

In the formation of the metal openings 8, a known etching method such as, e.g., dry etching (e.g., plasma etching) or wet etching (e.g., chemical etching), drilling, or laser processing is used, or preferably chemical etching is used.

Next, in the method, as shown in FIG. 4(h), the base openings 9 are formed in the insulating base layer 3.

In the formation of the base openings 9, a known etching method such as, e.g., dry etching (e.g., plasma etching) or wet etching (e.g., chemical etching), drilling, or laser processing is used, or preferably plasma etching is used.

As a result, the underlays 20 facing the terminal portions 11 in the thickness direction are exposed from the metal openings 8 of the metal supporting board 2 and from the base openings 9 of the insulating base layer 3.

Then, in the method, as shown in FIG. 4(i), the underlays 20 exposed from the metal openings 8 of the metal supporting board 2 and from the base openings 9 of the insulating base layer 3 are removed.

In the removal of the underlays 20, a known etching method such as, e.g., dry etching (e.g., plasma etching) or wet etching (e.g., chemical etching), stripping, or the like is used, or preferably stripping is used.

As a result, the back surfaces of the terminal portions 11 are exposed from the metal openings 8 of the metal supporting board 2 and from the base openings 9 of the insulating base layer 3.

Next, in the method, as shown in FIG. 4(j), the gold plating layer 7 is formed on the surfaces of the tin alloy layer 5 formed on the top surface and both side surfaces of the terminal portions 11, and on the back surface of the terminal portion 11 in continuous relation thereto.

The gold plating layer 7 is formed by electrolytic gold plating or electroless gold plating, or preferably electrolytic gold plating.

In the suspension board with circuit 1 and the producing method therefor, the tin alloy layer 5 is formed on the top surface and individual side surfaces of the conductive pattern 4 including the terminal portions 11 to allow a sufficient improvement in the strength of the terminal portions 11. As a result, it is possible to obtain the suspension board with circuit 1 having high connection reliability.

In addition, in the suspension board with circuit 1, the gold plating layer 7 is formed on the surfaces of the tin alloy layer 5 at each of the terminal portions 11 to allow a further improvement in the strength of the terminal portion 11.

In particular, in the method for producing the suspension board with circuit 1, the formed cover coating 23 is cured by heating and the tin alloy layer (tin-copper alloy layer) 5 in which tin is diffused in the conductive material (preferably copper) is also formed by the heating. Briefly, the heating for curing and the heating for diffusing are simultaneously performed. As a result, it is possible to simplify the production process, and easily and efficiently produce the suspension board with circuit 1.

Furthermore, in the suspension board with circuit 1, the tin alloy layer 5 is formed to cover the intersection portions 24. Accordingly, not only the terminal portions 11 but also the wires 12 in the vicinity of the intersection portions 24 can be reinforced. As a result, it is possible to prevent breakage of a wire in the conductive pattern 4 due to stress concentration on the intersection portions 24 and improve the strength of the conductive pattern 4.

FIG. 5 is a cross-sectional view of both the ends of a suspension board with circuit as another embodiment (in which the tin alloy layer is formed only on the top surface and both side surfaces of the terminal portions) of the wired circuit board according to the present invention, including a left-side view which is a partial cross-sectional view along the longitudinal direction and a right-side view which is a cross-sectional view along the widthwise direction. In each of the drawings shown hereinbelow, the same members as described above are designated by the same reference numerals, so that a description thereof is omitted.

In the description given above, the tin alloy layer 5 is formed at the same time as the uncured cover coating 23 is cured by heating. However, it is also possible to form the insulating cover layer 6 by, e.g., first, heating and curing the uncured cover coating 23, subsequently form the tin layer 21 by electroless tin plating, and then form the tin alloy layer 5 by heating and diffusing tin.

As shown in FIG. 5, in the suspension board with circuit 1 obtained by the method, the tin alloy layer 5 is provided continuously only on the surfaces of the terminal portions 11, i.e., on the top surface and both side surfaces (both widthwise side surfaces) of the terminal portions 11.

The tin alloy layer 5 is formed to erode the top surface and both widthwise side surfaces of the terminal portions 11.

As shown in the left-side view of FIG. 5, the tin alloy layer 5 is formed on the top surface and both side surfaces (not shown in FIG. 5) of the conductive pattern 4 on both longitudinal outsides of the intersection portions 24. In other words, both the longitudinal ends of the tin alloy layer 5 are formed to protrude outwardly in both longitudinal directions from the intersection portions 24 through diffusion of tin into copper. Accordingly, the tin alloy layer 5 is formed to have a longitudinal length larger than that of the terminal portions 11 (cover openings 10).

FIG. 6 is a cross-sectional view of both the ends of a suspension board with circuit as still another embodiment (in which the tin alloy layer is formed on the top surface, both side surfaces, and back surface of each of the terminal portions) of the wired circuit board according to the present invention.

In the description given above, the tin alloy layer 5 is provided on the top surface and both side surfaces of the terminal portions 11. However, it is also possible to further provide the tin alloy layer 5 on the back surface of the terminal portions 11.

As shown in FIG. 6, the tin alloy layer 5 is formed on the top surface, both side surfaces, and back surface of each of the terminal portions 11 in continuous relation thereto.

The tin alloy layer 5 is formed to erode the top surface, both widthwise side surfaces, and back surface of the terminal portions 11. As shown in the left-side view of FIG. 6, the tin alloy layer 5 is also formed on the back surface of the terminal portion 11 to have both the longitudinal ends thereof protruding outwardly in both longitudinal directions from the intersection portions 24 through diffusion of tin into copper.

The gold plating layer 7 is formed on the surfaces of the tin alloy layer 5 formed on the top surface, both side surfaces, and back surface of the terminal portions 11 in continuous relation thereto.

To produce the suspension board with circuit 1, e.g., first, the metal supporting board 2 is prepared (see FIG. 3(a)). Next, the insulating base layer 3 is formed on the metal supporting board 2 (see FIG. 3(b)). Next, the conductive pattern 4 is formed in the foregoing pattern on the insulating base layer 3 (see FIG. 3(c)). Next, the tin layer 21 is formed on the top surface and individual side surfaces (both widthwise side surfaces and both longitudinal side surfaces) of the conductive pattern 4 (see FIG. 3(d)). Next, the insulating cover layer 6 is formed in a pattern in which the cover openings 10 are formed, while the suspension board with circuit 1 in the process of production on which the tin layer 21 is formed is heated, so that the tin alloy layer 5 in which tin is diffused in the conductive material is formed on the surface of the conductive pattern 4 (see FIG. 3(e) and FIG. 3(f). Subsequently, the metal openings 8 are formed in the metal supporting board 2 (see FIG. 4(g)). Next, the base openings 9 are formed in the insulating base layer 3 (see FIG. 4(h)). Next, the underlays 20 exposed from the metal openings 8 of the metal supporting board 2 and from the base openings 9 of the insulating base layer 3 are removed (see FIG. 4(i)). Thereafter, the tin layer 21 is formed on the back surface of the terminal portions 11. Next, the suspension board with circuit 1 in the process of production on which the tin layer 21 is formed is heated, so that the tin alloy layer 5 in which tin is diffused in the conductive material is further formed on the back surface of the terminal portions 11. Thereafter, the gold plating layer 7 is formed on the surfaces of the tin alloy layer 5 formed on the top surface, both side surfaces, and back surface of each of the terminal portions 11.

In the suspension board with circuit 1, the tin alloy layer 5 is further formed on the back surface of the terminal portions 11 to allow a more sufficient improvement in the strength of the terminal portion 11.

In the description given above, the wired circuit board according to the present invention is described using the suspension board with circuit 1 including the metal supporting board 2 as an example. However, the wired circuit board according to the present invention is not limited thereto and is widely applicable to another wired circuit board such as, e.g., a flexible wired circuit board including the metal supporting board 2 as a reinforcing layer or a flexible wired circuit board not inlcuding the metal supporting board 2.

### Examples

The present invention is described more specifically by showing examples and a comparative example hereinbelow. However, the present invention is by no means limited to the examples and the comparative example.

EXAMPLE 1

A metal supporting board made of a stainless steel (SUS304) foil having a thickness of 20 µm was prepared (see FIG. 3(a)).

Then, a photosensitive polyamic acid resin solution was uniformly coated on the entire top surface of the metal supporting board and dried by heating at 90 °C to form a base coating. Subsequently, the base coating was exposed to light via a photomask, developed, and then cured (imidized) by heating at 370 °C to form an insulating base layer made of polyimide having a thickness of 10 µm in the foregoing pattern on the metal supporting board (see FIG. 3(b)).

Then, a chromium thin film having a thickness of 50 nm and a copper thin film having a thickness of 100 nm were successively formed on the entire top surface of the insulating base layer by a sputter deposition method to form an underlay. Then, a plating resist was formed in a pattern reverse to a conductive pattern on the top surface of the underlay. Thereafter, the conductive pattern made of copper having a thickness of 10 µm was formed by electrolytic copper plating (see FIG. 3(c)). The width of each of wires was 100 µm and the spacing between the individual wires was 20 µm.

Then, a tin layer having a thickness of 0.15 µm was formed by electroless tin plating on the top surface, both widthwise side surfaces, and both longitudinal side surfaces of the conductive pattern (see FIG. 3(d)).

Then, a photosensitive polyamic acid resin solution was coated on the entire top surface of the insulating base layer including the conductive pattern and the tin layer and dried by heating at 90 °C. Then, it was exposed to light via a photomask and developed to form a cover coating in a pattern in which cover openings having a longitudinal length of 1000 µm were formed and from which the tin layer was exposed (see FIG. 3(e)).

Then, the suspension board with circuit in the process of production on which the cover coating was formed was heated at 370°C under a reduced pressure for 120 minutes, so that the cover coating was cured (imidized) and a tin-copper alloy layer in which tin was diffused into copper was formed (see FIG. 3(f)). The thickness of the tin-copper alloy layer was 2.5 µm. The thickness of the tin-copper alloy layer was measured with a TOF-SIMS.

Then, metal openings were formed by performing chemical etching with respect to the metal supporting board (see FIG. 4(g)). Then, base openings were formed by performing plasma etching with respect to the insulating base layer (see FIG. 4(h)). Then, the underlays exposed from the metal openings and the base openings were removed by stripping (see FIG. 4(i)).

Thereafter, a gold plating layer having a thickness of 2 µm was formed by electrolytic gold plating on the surfaces of the tin-copper alloy layer formed on the top surface and both side surfaces of each of the terminal portions, and on the back surface of the terminal portion in continuous relation thereto (see FIG. 4(j)).

EXAMPLE 2

A suspension board with circuit was obtained by the same procedure as in EXAMPLE 1 except that the thickness of the tin layer was changed from 0.15 µm to 0.10 µm in the formation of the tin layer. The thickness of the tin-copper alloy layer was 2.0 µm.

EXAMPLE 3

A suspension board with circuit was obtained by the same procedure as in EXAMPLE 1 except that the thickness of the tin layer was changed from 0.15 µm to 0.05 µm in the formation of the tin layer. The thickness of the tin-copper alloy layer was 1.5 µm.

EXAMPLE 4

A suspension board with circuit was obtained by the same procedure as in EXAMPLE 1 except that the thickness of the tin layer was changed from 0.15 µm to 0.20 µm in the formation of the tin layer. The thickness of the tin-copper alloy layer was 2.5 µm.

EXAMPLE 5

A suspension board with circuit was obtained by the same procedure as in EXAMPLE 1 except that the thickness of the tin layer was changed from 0.15 µm to 0.01 µm in the formation of the tin layer. The thickness of the tin-copper alloy layer was 1.0 µm.

EXAMPLE 6

A suspension board with circuit was obtained by the same procedure as in EXAMPLE 1 except that the thickness of the tin layer was changed from 0.15 µm to 0.25 µm in the formation of the tin layer. The thickness of the tin-copper alloy layer was 2.5 µm.

EXAMPLE 7

A suspension board with circuit was obtained by the same procedure as in EXAMPLE 1 except that the thickness of the tin layer was changed from 0.15 µm to 0.005 µm in the formation of the tin layer. The thickness of the tin-copper alloy layer was 1.0 µm.

EXAMPLE 8

A suspension board with circuit was obtained by the same procedure as in EXAMPLE 1 except that the thickness of the tin layer was changed from 0.15 µm to 0.001 µm in the formation of the tin layer. The thickness of the tin-copper alloy layer was 0.5 µm.

EXAMPLE 9

A suspension board with circuit was obtained by the same procedure as in EXAMPLE 1 except that the thickness of the tin layer was changed from 0.15 µm to 0.30 µm in the formation of the tin layer. The thickness of the tin-copper alloy layer was 3.0 µm.

EXAMPLE 10

A suspension board with circuit was obtained by the same procedure as in EXAMPLE 1 except that the thickness of the tin layer was changed from 0.15 µm to 0.50 µm in the formation of the tin layer. The thickness of the tin-copper alloy layer was 3.5 µm.

EXAMPLE 11

A metal supporting board made of a stainless steel (SUS304) foil having a thickness of 20 µm was prepared (see FIG. 3(a)).

Then, a photosensitive polyamic acid resin solution was uniformly coated on the entire top surface of the metal supporting board and dried by heating at 90°C to form a base coating. Subsequently, the base coating was exposed to light via a photomask, developed, and then cured (imidized) by heating at 370 °C to form an insulating base layer made of polyimide having a thickness of 10 µm on the metal supporting board (see FIG. 3(b)).

Then, a chromium thin film having a thickness of 50 nm and a copper thin film having a thickness of 100 nm were successively formed by a sputter deposition method on the entire top surface of the insulating base layer to form an underlay. Then, a plating resist was formed in a pattern reverse to a conductive pattern on the top surface of the underlay. Thereafter, the conductive pattern made of copper having a thickness of 10 µm was formed by electrolytic copper plating (see FIG. 3(c)). The width of each of wires was 20 µm and the spacing between the individual wires was 20 µm.

Then, a tin layer having a thickness of 0.15 µm was formed by electroless tin plating on the top surface, both widthwise side surfaces, and both longitudinal side surfaces of the conductive pattern (see FIG. 3(d)).

Then, a photosensitive polyamic acid resin solution was coated on the entire top surface of the insulating base layer including the conductive pattern and dried by heating at 90 °C. Subsequently, it was exposed to light via a photomask, developed, and then cured (imidized) by heating at 370 °C to form an insulating cover layer in a pattern in which cover openings having a longitudinal length of 1000 µm were formed. At the same time, a tin-copper alloy layer in which tin was diffused into copper was formed on the top surface, both widthwise side surfaces, and both longitudinal side surfaces of the conductive pattern including the terminal portions (see FIG. 3(e) and FIG. 3(f)). The thickness of the tin-copper alloy layer was 2.5 µm.

Then, metal openings were formed by performing chemical etching with respect to the metal supporting board (see FIG. 4(g)). Then, base openings were formed by performing plasma etching with respect to the insulating base layer (see FIG. 4(h)). Then, the underlays exposed from the metal openings and the base openings were removed by stripping (see FIG. 4(i)).

Then, a tin layer having a thickness of 0.15 µm was formed on the back surface of the conductive pattern by electroless tin plating using the insulating base layer as a plating resist.

Then, the suspension board with circuit in the process of production on which the tin layer was formed was heated at 370°C for 120 minutes, so that a tin-copper alloy layer in which tin was diffused into copper was formed further on the back surface of the terminal portions. The thickness of the tin-copper alloy layer was 2.5 µm.

Thereafter, a gold plating layer having a thickness of 2 µm was formed by electrolytic gold plating on the surfaces of the tin-copper alloy layer formed on the top surface, both side surfaces, and back surface of the terminal portions in continuous relation thereto (see FIG. 6).

COMPARATIVE EXAMPLE 1

A suspension board with circuit was obtained by the same procedure as in EXAMPLE 1 except that a tin layer was not formed. That is, in the suspension board with circuit, a tin-copper alloy layer was not formed and a gold plating layer was formed on the top surface, both side surfaces, and back surface of the terminal portions.

(Evaluation)

### (1) Connection Strength

The external connection terminals of the suspension boards with circuit obtained in each of the examples and the comparative example were connected to the respective terminal portions made of gold pads of a read/write board by using a bonding tool and applying ultrasonic vibration thereto. Thereafter, a peel release test to strip in a 180-degree direction using a multi-purpose tester (TENSILON available from A&D Co., LTD) was performed and the connection strengths of the external connection terminals were measured, the result of which is shown in Table 1.

### (2) Surface Resistance

The surface resistivities of the external connection terminals of the suspension boards with circuit obtained in each of the examples and the comparative example were measured at a temperature of 25°C and a humidity of 15% using a surface resistance measuring device (Hiresta-up MCP-HT450 available from Mitsubishi Chemical Corporation), the result of which is shown in Table 1.

**Table 1**

| Examples/Comparative Example | | | Example 1 | Example 2 | Example 3 | Example 4 | Example 5 | Example 6 | Example 7 | Example 8 | Example 9 | Example 10 | Example 11 | Comparative Exaple 1 |
|---|---|---|---|---|---|---|---|---|---|---|---|---|---|---|
| Tin Layer | (Before Heating) | Thickness (µm) | 0.15 | 0.10 | 0.05 | 0.20 | 0.01 | 0.25 | 0.005 | 0.001 | 0.30 | 0.50 | 0.15 | - |
| Tin-Copper Alloy Layer | (After Heating) | Layer-Formed Surface of Terminal Portion | Top and Both Side Surfaces | | | | | | | | | | Top, Both Side, and Back Surfaces | - |
| | | Thickness (µm) | 2.5 | 2.0 | 1.5 | 2.5 | 1.0 | 2.5 | 1.0 | 0.5 | 3.0 | 3.5 | 2.5 | - |
| Evaluation | | Connetion Strength (MPa) | 200 | 200 | 200 | 200 | 180 | 200 | 160 | 140 | 200 | 200 | 200 | 130 |
| | | Surface Resistivity (Ω · cm) | 2.30 x 10⁻⁸ | 2.26 x 10⁻⁸ | 2.15 x 10⁻⁸ | 2.31 x 10⁻⁸ | 2.05 x 10⁻⁸ | 2.30 x 10⁻⁸ | 1.99 x 10⁻⁸ | 1.91 x 10⁻⁸ | 2.31 x 10⁻⁸ | 2.50 x 10⁻⁸ | 2.20 x 10⁻⁸ | 1.90 x 10⁻⁸ |

## Claims

1. A wired circuit board comprising:
a first insulating layer;
a conductive pattern formed on the first insulating layer and having a terminal portion; and
a second insulating layer formed on the first insulating layer to cover the conductive pattern, wherein
a surface of the terminal portion is formed to be exposed from the first insulating layer and the second insulating layer, and
a tin alloy layer is formed at least on a top surface and both side surfaces of the terminal portion.

2. The wired circuit board according to Claim 1, wherein the tin alloy layer is further formed on a back surface of the terminal portion.

3. The wired circuit board according to Claim 1, wherein a gold plating layer is formed on a surface of at least the tin alloy layer at the terminal portion.

4. The wired circuit board according to Claim 1, wherein the tin alloy layer has a thickness of 1.0 to 3.0 µm.

5. The wired circuit board according to Claim 1, wherein
the conductive pattern is formed of copper, and
the tin alloy layer is a tin-copper alloy layer formed by diffusing tin into copper.

6. The wired circuit board according to Claim 1, wherein the wired circuit board is a suspension board with circuit.

7. A method for producing a wired circuit board, the method comprising the steps of:
preparing a metal supporting board;
forming an insulating base layer on the metal supporting board;
forming a conductive pattern having a terminal portion and formed of copper on the insulating base layer;
forming a tin layer at least on a top surface and both side surfaces of the terminal portion;
forming an insulating cover layer on the insulating base layer to cover the conductive pattern and exposing the top surface and both the side surfaces of the terminal portion;
forming a tin-copper alloy layer by heating the tin layer to diffuse tin into copper at least on the top surface and both the side surfaces of the terminal; and
forming a metal opening and a base opening respectively in the metal supporting board and the insulating base layer to expose a back surface of the terminal portion.

8. The method for producing a wired circuit board according to Claim 7, further comprising the step of:
forming a gold plating layer on a surface of at least the tin-copper alloy layer at the terminal portion.

9. The method for producing a wired circuit board according to Claim 7,
the step of forming the insulating cover layer comprising the steps of:
laminating an uncured resin; and
curing the laminated uncured resin by heating, wherein
the step of curing the uncured resin by heating and the step of forming the tin-copper alloy layer are carried out simultaneously.

10. The method for producing a wired circuit board according to Claim 7, wherein the tin layer has a thickness of 0.01 to 0.20 µm.
